# EUROPEAN PATENT APPLICATION

(11) **EP 4 675 223 A1**
(43) Date of publication of application: **07.01.2026**
(21) Application number: 24788626.0
(22) Date of filing: 02.04.2024
(51) Int. Cl.: G01B 11/25, G01B 11/24, H01L 21/66

(54) **CONTOUR SHAPE MEASURING DEVICE AND METHOD**

(30) Priority: 11.04.2023 JP 2023064267; 18.03.2024 JP 2024042104
(71) Applicant: Kobelco Research Institute, Inc., Kobe-shi, Hyogo 651-0073 (JP)
(72) Inventor: FURUTA, Yohei, Hyogo 651-2271 (JP); YONEDA, Nao, Hyogo 651-2271 (JP); NISHIDA, Hiroto, Hyogo 651-2271 (JP); MORIMOTO, Tsutomu, Hyogo 651-2271 (JP); SHIMPO, Hideki, Hyogo 676-8670 (JP)
(74) Representative: Müller-Boré & Partner Patentanwälte PartG mbB
(86) International application number: PCT/JP2024/013674
(87) International publication number: WO 2024/214599

(57) **Abstract**

The present invention relates to a contour shape measuring device and a method for measuring a contour shape in a disk-shaped measurement target object having a beveled peripheral edge portion, in which the contour shape is measured as a shadow contour shape on the basis of a shadow image obtained by imaging a shadow of the peripheral edge portion generated by applying light onto the peripheral edge portion from a tangential direction of an outer periphery, the contour shape of the peripheral edge portion is measured as an optical contour shape by measuring a distance to the measurement target object using light from a surface direction, and the contour shape is obtained on the basis of the shadow contour shape and the optical contour shape.

## Description

### Technical Field

The present invention relates to a contour shape measuring device and a contour shape measuring method for measuring a contour shape in a disk-shaped measurement target object having a beveled peripheral edge portion.

### Background Art

A device for measuring a contour shape in a disk-shaped measurement target object is disclosed in, for example, Patent Literature 1. A shape measuring device disclosed in Patent Literature 1 includes a light projecting means for projecting light from a direction parallel to each of front and back surfaces of a disk-shaped measurement target object to a measuring unit including an end portion chamfered in the measurement target object, and an imaging means for imaging the measuring unit from a direction facing the light projecting direction, and measures a contour shape of the measuring unit by performing image processing on a projection image of the measuring unit obtained by the imaging means, the shape measuring device including: a thickness measuring means for measuring a thickness of a reference position of the measuring unit of the measurement target object; an image processing means for deriving first contour shape information of the measuring unit by image processing on a projection image of the measuring unit; and a contour shape correction means for correcting the first contour shape information by correcting a thickness distribution specified from the first contour shape information and outputting corrected second contour shape information on the basis of a thickness measured by the thickness measuring means and a dimension of the measuring unit in the light projecting direction.

By the way, when a wafer whose outer peripheral edge portion is R-chamfered is extremely thinned, edge pitching occurs due to the influence of the R-shape of the R-chamfering, and the wafer may be broken starting from the edge pitching. In order to prevent this wafer cracking, trimming (edge trimming) to provide a step in the height direction by scraping the R shape with a polishing blade may be performed. When an attempt is made to measure the contour shape of such a trimmed wafer on the basis of a shadow of the wafer caused by light applied to the wafer as in the shape measuring device disclosed in Patent Literature 1, the shape of the stepped portion may be blurred due to scattering of light or the like generated in the stepped portion, and the measurement accuracy may be deteriorated.

### Citation List

### Patent Literature

Patent Literature 1: JP 2009-156686 A

### Summary of Invention

The present invention has been made in view of the above circumstances, and an object thereof is to provide a contour shape measuring device and a contour shape measuring method capable of measuring a contour shape with higher accuracy.

The present invention relates to a contour shape measuring device and a contour shape measuring method for measuring a contour shape in a disk-shaped measurement target object having a beveled peripheral edge portion, in which the contour shape is measured as a shadow contour shape on a basis of a shadow image obtained by imaging a shadow of the peripheral edge portion generated by applying light onto the peripheral edge portion from a tangential direction of an outer periphery, the contour shape of the peripheral edge portion is measured as an optical contour shape by measuring a distance to the measurement target object using light from a surface direction, and the contour shape is obtained on a basis of the shadow contour shape and the optical contour shape.

The above and other objects, features and advantages of the present invention will be apparent from the following detailed description and accompanying drawings.

### Brief Description of Drawings

FIG. 1 is a block diagram illustrating a configuration of a contour shape measuring device according to a first embodiment.
FIG. 2 is a schematic diagram for explaining a measurement system in the contour shape measuring device according to the first embodiment.
FIG. 3 is a schematic diagram for explaining a stage in the contour shape measuring device of the embodiment.
FIG. 4 is a diagram for explaining a shape of a trimmed measurement target object.
FIG. 5 is a diagram for explaining a cause of noise.
FIG. 6 is a diagram for explaining superposition of a shadow contour shape and an optical sectional contour shape.
FIG. 7 is a flowchart illustrating an operation of the contour shape measuring device according to the first embodiment.
FIG. 8 is a block diagram illustrating a configuration of a contour shape measuring device according to a second embodiment.
FIG. 9 is a schematic diagram for explaining a measurement system in the contour shape measuring device according to the second embodiment.
FIG. 10 is a flowchart illustrating an operation of the contour shape measuring device according to the second embodiment.
FIG. 11 is a block diagram illustrating a configuration of a contour shape measuring device according to a third embodiment.
FIG. 12 is a schematic diagram for explaining a measurement system in the contour shape measuring device according to the third embodiment.
FIG. 13 is a flowchart illustrating an operation of the contour shape measuring device according to the third embodiment.

### Description of Embodiments

Hereinafter, one or a plurality of embodiments of the present invention will be described with reference to the drawings. However, the scope of the invention is not limited to the disclosed embodiments. Note that in the drawings, the same reference signs denote the same components, and description thereof will be appropriately omitted. In the present specification, when components are collectively referred to, the components will be denoted by reference signs with suffixes omitted, and when components are individually referred to, the components will be denoted by reference signs with suffixes.

A contour shape measuring device according to the embodiment is a device that measures a contour shape in a disk-shaped measurement target object having a beveled peripheral edge portion. The contour shape measuring device includes a shadow contour shape measuring unit, an optical contour shape measuring unit, and a contour shape calculating unit. The shadow contour shape measuring unit measures the contour shape as a shadow contour shape on the basis of a shadow image obtained by imaging a shadow of the peripheral edge portion generated by applying light onto the peripheral edge portion from a tangential direction of an outer periphery. The optical contour shape measuring unit measures the contour shape of the peripheral edge portion as an optical contour shape by measuring a distance to the measurement target object using light from a surface direction. The contour shape calculating unit obtains the contour shape on the basis of the shadow contour shape measured by the shadow contour shape measuring unit and the optical contour shape measured by the optical contour shape measuring unit. Hereinafter, such a contour shape measuring device and a contour shape measuring method mounted on the contour shape measuring device will be described more specifically with reference to the first to third embodiments.

### (First Embodiment)

In the contour shape measuring device according to a first embodiment, an optical sectional contour shape measuring unit that measures the optical contour shape as an optical sectional contour shape from the surface direction by an optical cutting method is used as the optical contour shape measuring unit. That is, the contour shape measuring device according to the first embodiment includes a shadow contour shape measuring unit, an optical sectional contour shape measuring unit, and a contour shape calculating unit similar to those described above. The optical sectional contour shape measuring unit measures the contour shape of the peripheral edge portion as an optical sectional contour shape from a surface direction by an optical cutting method. The contour shape calculating unit obtains the contour shape on the basis of the shadow contour shape measured by the shadow contour shape measuring unit and the optical sectional contour shape measured by the optical sectional contour shape measuring unit. Hereinafter, a description will be given more specifically.

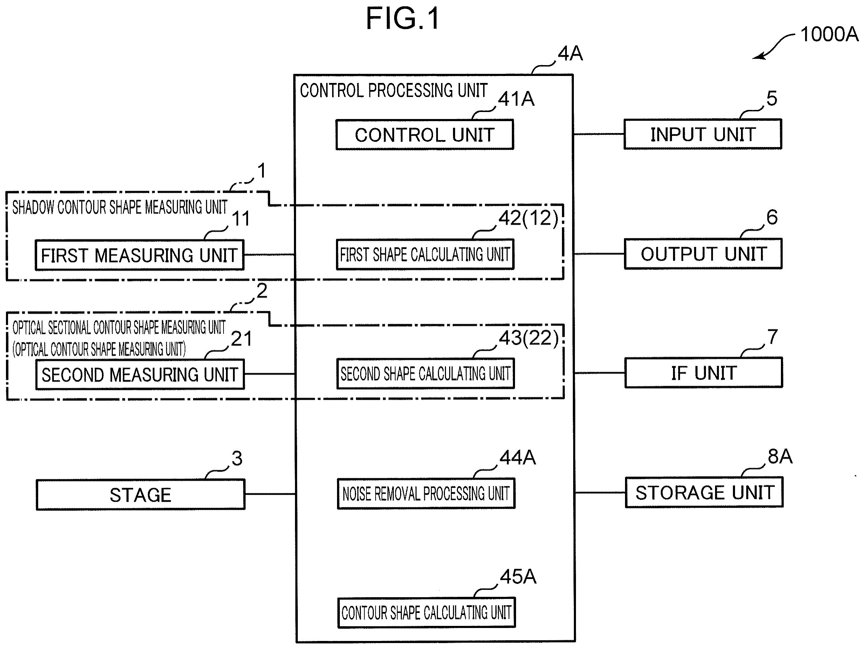

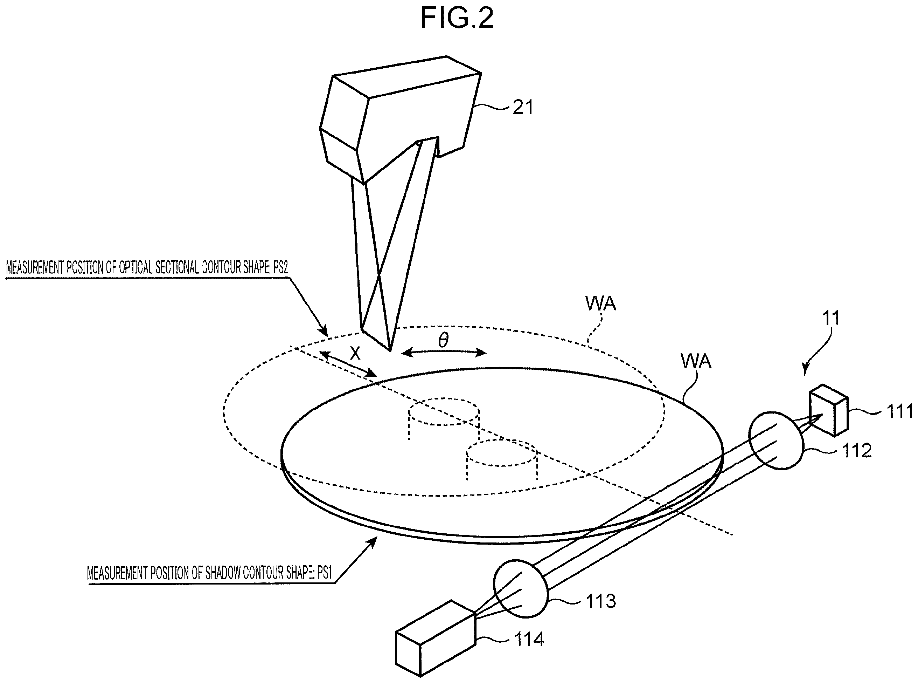

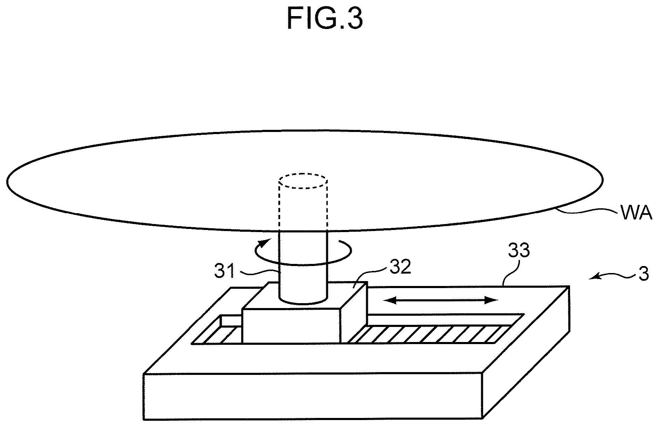

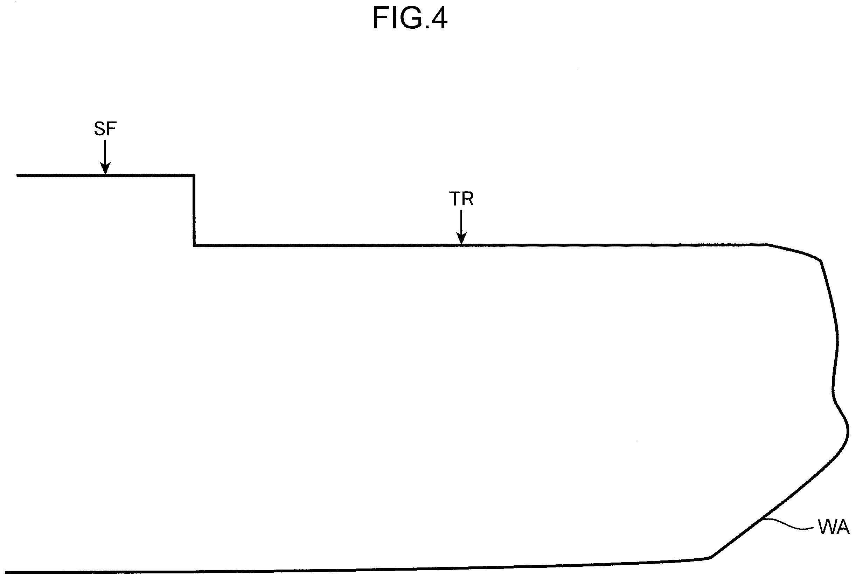

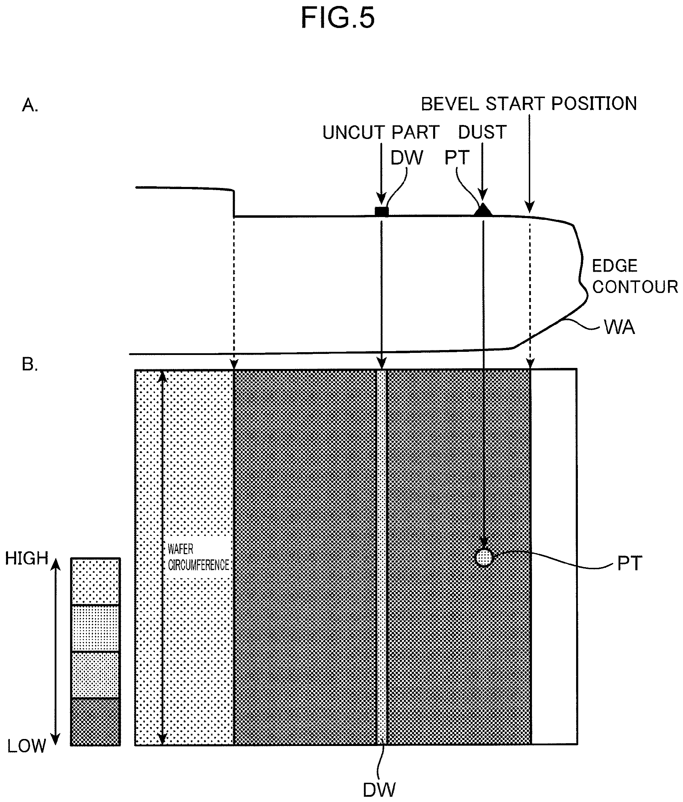

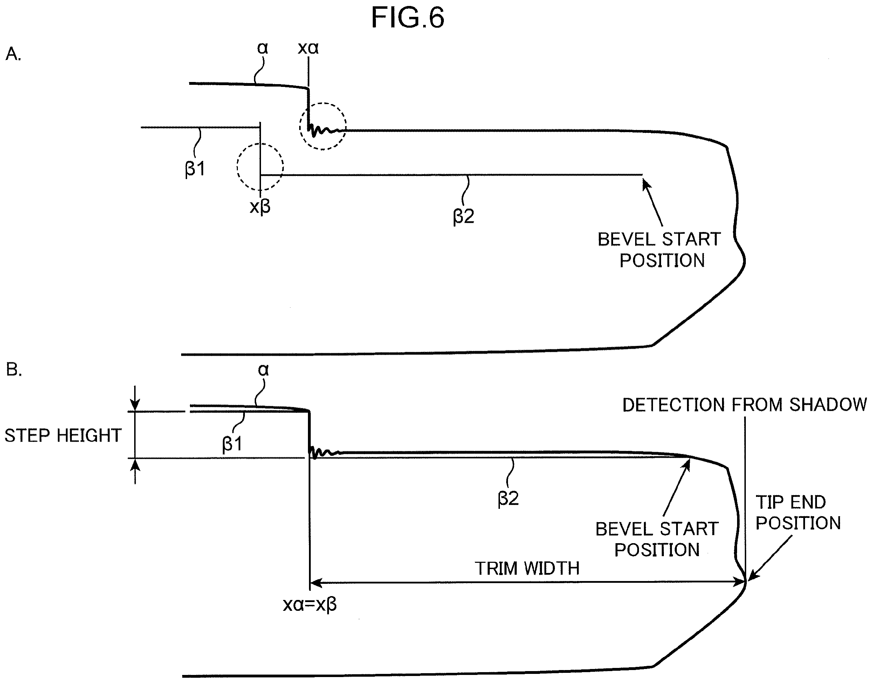

FIG. 1 is a block diagram illustrating a configuration of the contour shape measuring device according to the first embodiment. FIG. 2 is a schematic diagram for explaining a measurement system in the contour shape measuring device of the first embodiment. FIG. 3 is a schematic diagram for explaining a stage in the contour shape measuring device of the embodiment. Note that FIG. 3 schematically illustrates a stage in the contour shape measuring devices of the first to third embodiments. FIG. 4 is a diagram for explaining a shape of a trimmed measurement target object. FIG. 5 is a diagram for explaining a cause of noise. FIG. 5A is a cross-sectional view schematically illustrating a peripheral edge portion of a measurement target object WA which is an example of the measurement target object, and FIG. 5B is a schematic plan view of the measurement target object WA in which a height (thickness) of the measurement target object WA is represented by gray scale. In FIG. 5B, the measurement target object WA has a disk shape, but the measurement target object WA is illustrated by converting the circumferential direction into a straight line. FIG. 6 is a diagram for explaining superposition of a shadow contour shape and an optical sectional contour shape. FIG. 6A shows before superposition, and FIG. 6B shows after superposition.

For example, as illustrated in FIGS. 1 to 3, a contour shape measuring device 1000A according to the first embodiment includes a shadow contour shape measuring unit 1, an optical sectional contour shape measuring unit 2, a stage 3, a control processing unit 4A, an input unit 5, an output unit 6, an interface unit (IF unit) 7, and a storage unit 8A.

The stage 3 is a device that supports the measurement target object WA with the measurement target object WA placed thereon, is connected to the control processing unit 4A, rotates the measurement target object WA in a circumferential direction θ under the control of the control processing unit 4A, and moves the measurement target object WA in a predetermined movement range in the horizontal direction orthogonal to the height direction (thickness direction). In the present embodiment, for example, as illustrated in FIG. 3, the stage 3 includes a columnar rotation supporting member 31 on which supports the measurement target object WA to be placed and which supports the measurement target object WA and serves as a rotation axis, a drive unit 32 that rotationally drives the rotation supporting member 31 and linearly moves in the horizontal direction within the predetermined movement range, and a pedestal 33 that supports the rotation supporting member 31 and the drive unit 32. One end surface of the rotation supporting member 31 is a horizontal plane on which the measurement target object WA is placed. For example, a through opening connected to a suction pump (not illustrated) is formed in the rotation supporting member 31 along a central axis thereof, and the measurement target object WA is pulled from the through opening by a negative pressure of the suction pump and fixed to the one end surface. The drive unit 32 is rotatably connected to the rotation supporting member 31 at the other end thereof, and includes a drive mechanism for rotationally driving the rotation supporting member 31. The drive mechanism includes, for example, an actuator such as a servo motor and a reduction gear. The drive unit 32 is configured to linearly move with respect to the pedestal 33 by, for example, a rack and pinion, the pedestal 33 is configured to include a rack, and the drive unit 32 further includes a pinion for linearly moving on the rack and an actuator such as, for example, a servo motor for rotating the pinion. In such a stage 3, the measurement target object WA placed and fixed on one end surface of the rotation supporting member 31 is rotated in the circumferential direction θ by the rotation supporting member 31 being rotated by the drive unit 32, and linearly moved in the horizontal direction by moving on the pedestal 33 by the drive unit.

The measurement target object WA may have any shape as long as the measurement target object WA has a disk shape having a beveled peripheral edge portion, and is, for example, a wafer (for example, a silicon wafer) used for manufacturing a semiconductor, a substrate for a magnetic disk made of aluminum or glass used for a hard disk, or the like. The beveling is, for example, trimming (edge trimming) in which one or a plurality of steps in the height direction are provided in the radial direction X. In the trimming, for example, a step in the height direction is formed as illustrated in FIG. 4 by cutting the surface of the peripheral edge portion of the measurement target object WA substantially flat by the polishing blade. In the example illustrated in FIG. 4, one trim (frame) TR is formed. The original wafer surface SF and the trim TR form a substantially vertical step and are formed in a stepped shape.

The shadow contour shape measuring unit 1 is a device that measures the contour shape of the measurement target object WA as a shadow contour shape on the basis of a shadow image obtained by imaging a shadow of the peripheral edge portion generated by applying light onto the peripheral edge portion of the measurement target object WA from a tangential direction of the outer periphery. The shadow contour shape measuring unit 1 sequentially rotates the measurement target object WA at a predetermined angular interval (sampling interval) by the stage 3, and measures each shadow contour shape (each outer contour shape of a cross section along each radial direction of each measurement point) viewed from the side at each measurement point (sampling point) in the circumferential direction. The shadow contour shape measuring unit 1 includes, for example, a first measuring unit 11 and a first shape calculating unit 12 (42).

The first measuring unit 11 is a device that is connected to the control processing unit 4A, generates a shadow of the peripheral edge portion by applying light onto the peripheral edge portion of the measurement target object WA from a tangential direction of the outer periphery under the control of the control processing unit 4A, and images the generated shadow of the peripheral edge portion. For example, as illustrated in FIG. 2, such a first measuring unit 11 includes an illumination unit 111, an illumination optical system 112, a light receiving optical system 113, and an imaging unit 114. The illumination unit 111 is connected to the control processing unit 4A and emits illumination light under the control of the control processing unit 4A, and includes a light source such as a white light emitting diode, for example. The illumination optical system 112 collimates the illumination light radiated (irradiated) from the illumination unit 111 to parallel light, and includes, for example, one or a plurality of lenses. The light receiving optical system 113 forms an optical image of a shadow of the peripheral edge portion generated by applying the illumination light of the parallel light to the peripheral edge portion of the measurement target object WA on an imaging surface (light receiving surface) of the imaging unit 114, and includes, for example, one or a plurality of lenses. The imaging unit 114 is connected to the control processing unit 4A and converts the optical image of the shadow of the peripheral edge portion formed on the imaging surface into an electrical signal under the control of the control processing unit 4A, and includes, for example, a CCD area image sensor or a CMOS area image sensor. The imaging unit 114 outputs data (shadow data) obtained by this imaging to the control processing unit 4A. The illumination unit 111, the illumination optical system 112, the light receiving optical system 113, and the imaging unit 114 are disposed in this order so that their optical axes coincide with each other.

In the present embodiment, the first shape calculating unit 12 (42) is functionally configured in the control processing unit 4A as described later, generates shadow image data that is data representing an image (shadow image) of a shadow of the peripheral edge portion by performing image processing (first image processing) on an output (shadow data) of the imaging unit 114, and generates a contour shape of the measurement target object WA as a shadow contour shape by performing image processing (second image processing) on the generated shadow image data. The second image processing includes, for example, 21st image processing of extracting an edge by an edge filter such as a Sobel filter, 22nd image processing of removing noise from the edge extracted in the 21st image processing by a preset luminance threshold, and 23rd image processing of obtaining a curve to be fitted to the edge after noise removal by the 22nd image processing as the shadow contour shape in units of subpixels.

The optical sectional contour shape measuring unit 2 is a device that measures a contour shape of a peripheral edge portion of the measurement target object WA as an optical sectional contour shape from a surface direction by an optical cutting method. The optical sectional contour shape measuring unit 2 sequentially rotates the measurement target object WA at the predetermined angular interval (the sampling interval) by the stage 3, and measures each optical sectional contour shape (each outer contour shape (outer contour shape on the irradiation side of the illumination light) of the cross section along each radial direction of each measurement point) viewed from the side at each measurement point (the sampling point) in the circumferential direction. The optical sectional contour shape measuring unit 2 includes, for example, a second measuring unit 21 and a second shape calculating unit 22 (43). The second measuring unit 21 is a device that is connected to the control processing unit 4A, emits illumination light in a linear slit shape under the control of the control processing unit 4A, and receives reflected light of the illumination light reflected by the measurement target object WA. The second measuring unit 21 outputs data (optical sectional data) obtained by the light reception to the control processing unit 4A. The second measuring unit 21 includes, for example, a light source, a slit member that forms light emitted from the light source into slit-shaped illumination light, and an image sensor that receives reflected light of the illumination light and captures an image, and the image sensor outputs optical sectional data obtained by this imaging to the control processing unit 4A. In the present embodiment, as will be described later, the second shape calculating unit 22 (43) is functionally configured in the control processing unit 4A, and obtains the contour shape of the peripheral edge portion in the measurement target object WA as the optical sectional contour shape by processing the output (the optical sectional data) of the second measuring unit 21 according to the optical cutting method. In the optical cutting method, the light receiving direction (light receiving angle) of the reflected light changes according to the distance from the second measuring unit 21 to the surface of the measurement target object WA, and the distance from the second measuring unit 21 to the surface of the measurement target object WA is obtained by using the principle of triangulation from the traveling direction (irradiation angle) of the illumination light, the light receiving direction (light receiving angle) of the reflected light, and the distance (base line length) between the irradiation position of the illumination light and the light receiving position of the reflected light. By obtaining this distance, the contour shape (optical sectional contour shape) of the peripheral edge portion of the measurement target object WA is obtained from the surface direction.

In the first embodiment, as described above, the optical sectional contour shape measuring unit 2 corresponds to an example of the optical contour shape measuring unit that measures the contour shape of the peripheral edge portion as the optical contour shape by measuring the distance to the measurement target object using light from the surface direction.

As illustrated in FIG. 2, the first measuring unit 11 and the stage 3 are disposed such that, when the measurement target object WA is moved to a measurement position PS1 of the shadow contour shape (the position where the shadow contour shape measuring unit 1 measures the shadow contour shape of the measurement target object WA) by the stage 3, the peripheral edge portion of the measurement target object WA is positioned between the illumination optical system 112 and the light receiving optical system 113 in the first measuring unit 11, and the tangential direction of the outer periphery of the measurement target object WA and the optical axis of the first measuring unit 11 coincide with each other or are parallel to each other. The measurement position PS1 of the shadow contour shape is a position of the measurement target object WA when the shadow contour shape measuring unit 1 measures the shadow contour shape. As illustrated in FIG. 2, the second measuring unit 21 and the stage 3 are disposed such that, when the measurement target object WA is moved to a measurement position PS2 of the optical sectional contour shape by the stage 3, the extending direction of the slit-shaped illumination light in the second measuring unit 21 (the direction in which the illumination light extends in the slit shape) coincides with the radial direction X of the measurement target object WA, and the peripheral edge portion of the measurement target object WA is illuminated with the slit-shaped illumination light in the second measuring unit 21. The measurement position PS2 of the optical sectional contour shape is a position of the measurement target object WA when the optical sectional contour shape measuring unit 2 measures the optical sectional contour shape. The first measuring unit 11 of the shadow contour shape measuring unit 1, the second measuring unit 21 of the optical sectional contour shape measuring unit 2, and the stage 3 are disposed and fixed as described above.

Then, the predetermined movement range when the drive unit 32 in the stage 3 is moved in the horizontal direction is defined such that, for example, when the drive unit 32 moves to one end, the measurement target object WA is located at the measurement position PS1 of the shadow contour shape as illustrated in FIG. 2, and when the drive unit 32 moves to the other end, the measurement target object WA is located at the measurement position PS2 of the optical sectional contour shape.

The input unit 5 is a device that is connected to the control processing unit 4A and inputs, to the contour shape measuring device 1000A, various commands such as a command for instructing start of measurement, and various data necessary for operating the contour shape measuring device 1000A such as a measurement target object name, and is, for example, a keyboard, a mouse, a plurality of input switches assigned with predetermined functions, and the like. The output unit 6 is a device that is connected to the control processing unit 4A and outputs commands, data, and contour shapes input from the input unit 5 under control of the control processing unit 4A. Examples of the output unit 6 are a display device, such as a cathode ray tube (CRT) display, a liquid crystal display (LCD), or an organic electroluminescence (EL) display, and a printing device such as a printer.

Note that the input unit 5 and the output unit 6 may be constituted by a touch panel. When the touch panel is constituted, the input unit 5 is a position input device that detects and inputs operation positions of a resistance film system or a capacitive system, for example. The output unit 6 is a display device. In this touch panel, the position input device is provided on a display surface of the display device, and one or a plurality of input content candidates that can be input are displayed on the display device. When a user touches a display position where an input content desired to be input is displayed, the position input device detects the touched position, and the display content displayed at the detected position is input to the contour shape measuring device 1000A as a user's operation input content. In such a touch panel, since the user can easily and intuitively understand the input operation, the contour shape measuring device 1000A that is easy for the user to handle is provided.

The IF unit 7 is a circuit that is connected to the control processing unit 4A and inputs or outputs data to or from an external device under control of the control processing unit 4A. Examples of the IF unit 7 are an interface circuit of RS-232C which is a serial communication system, an interface circuit using the Bluetooth (registered trademark) standard, and an interface circuit using the Universal Serial Bus (USB) standard. Further, the IF unit 7 may be a communication interface circuit, such as a data communication card, or a communication interface circuit according to the IEEE 802.11 standard, that transmits and receives a communication signal with an external device.

The storage unit 8A is a circuit that is connected to the control processing unit 4A and stores various predetermined programs and various predetermined data under the control of the control processing unit 4A. The various predetermined programs include, for example, a first control processing program, and the first control processing program includes, for example, a first control program, a first shape calculation program, a second shape calculation program, a noise removal program, a first contour shape calculation program, and the like. The first control program is a program for controlling each of the units 1 to 3, 5 to 7, and 8A of the contour shape measuring device 1000A according to the function of each of the units. The first shape calculation program is a program that generates the shadow image data by performing the first image processing on the output of the imaging unit 114 and obtains the shadow contour shape by performing the second image processing on the generated shadow image data. The second shape calculation program is a program for obtaining the optical sectional contour shape by processing the output of the second measuring unit 21 according to an optical cutting method. The noise removal program is a program for removing noise generated in the height direction from the optical sectional contour shape measured by the optical sectional contour shape measurement program to obtain a noise-removed contour shape. The first contour shape calculation program is a program for obtaining the contour shape on the basis of a shadow contour shape obtained by the shadow contour shape measurement program and an optical sectional contour shape obtained by the second shape calculation program of the optical sectional contour shape measurement program.

The various types of predetermined data include, for example, data necessary for executing these programs, such as a measurement target object name, positional relationship information, each data during information processing, a contour shape, and the like. The positional relationship information is information indicating a positional relationship between a measurement position (first measurement position) of the first measuring unit 11 in the shadow contour shape measuring unit 1 and a measurement position (second measurement position) of the second measuring unit 21 in the optical sectional contour shape measuring unit 2. Since the shadow contour shape measuring unit 1, the optical sectional contour shape measuring unit 2, and the stage 3 are fixedly disposed as described above, the positional relationship between the first measurement position and the second measurement position can be defined in advance, and from the positional relationship information, the shadow contour shape and the optical sectional contour shape at each measurement point can be made to correspond to each other for each measurement point.

Such a storage unit 8A includes a read only memory (ROM) that is a nonvolatile storage element, and an electrically erasable programmable read only memory (EEPROM) that is a rewritable nonvolatile storage element. The storage unit 8A includes a random access memory (RAM) serving as a so-called working memory of the control processing unit 4A, the working memory storing data and the like generated during execution of the predetermined programs. Furthermore, the storage unit 8A may include a hard disk device having a relatively large storage capacity.

The control processing unit 4A is a circuit for controlling each of the units 1 to 3, 5 to 7, and 8A of the contour shape measuring device 1000A according to the function of each unit to obtain the contour shape of the measurement target object WA. The control processing unit 4A includes, for example, a central processing unit (CPU) and its peripheral circuits. In the control processing unit 4A, a control unit 41A, a first shape calculating unit 42 (12), a second shape calculating unit 43 (22), a noise removal processing unit 44A, and a contour shape calculating unit 45A are functionally configured by executing the first control processing program.

The control unit 41 A controls each of the units 1 to 3, 5 to 7, and 8A of the contour shape measuring device 1000A according to the function of each unit, and controls the entire contour shape measuring device 1000A.

As described above, the first shape calculating unit 42 (12) generates the shadow image data by performing the first image processing on the output (shadow data) of the imaging unit 114, and obtains the shadow contour shape by performing the second image processing on the generated shadow image data. For each of the measurement points, a shadow contour shape of the measurement point is generated.

As described above, the second shape calculating unit 43 (22) obtains the optical sectional contour shape by processing the output (optical sectional data) of the second measuring unit 21 according to the optical cutting method. For each of the measurement points, an optical sectional contour shape of the measurement point is generated.

The noise removal processing unit 44A removes noise generated in the height direction from the optical sectional contour shape measured by the optical sectional contour shape measuring unit 2 to obtain a noise-removed contour shape. For each of the optical sectional contour shapes, a noise-removed contour shape of the optical sectional contour shape is generated (a noise-removed contour shape of the measurement point is generated for each of the measurement points). In the trim processing, as described above, since cutting is performed with the polishing blade, for example, as illustrated in FIG. 5, an uncut part DW, a shaving (dust) PT, and the like may occur, and the uncut part DW, the shaving (dust) PT, and the like become contour shape noise. The noise removal processing unit 44A removes this noise from the optical sectional contour shape measured by the optical sectional contour shape measuring unit 2. More specifically, the noise removal processing unit 44A removes the noise using a threshold (noise determination threshold) corresponding to a variation in height obtained on the basis of the optical sectional contour shape measured by the optical sectional contour shape measuring unit 2. More specifically, the noise removal processing unit 44A first obtains a standard deviation σ of the height from the optical sectional contour shape corresponding to the trim TR, and sets a noise determination threshold Thn to a predetermined value m times the standard deviation σ of the height (Thn = m × σ). The standard deviation σ of the height corresponds to an example of the variation in the height. Here, in a case where the assumed size of dust is denoted by Dd, and the depth of the trim TR (the length of the step) is denoted by St, the predetermined value m is preferably set such that the noise determination threshold Thn falls within a range of Dd/5 or more and St/2 or less (Dd/5 ≤ Thn ≤ St/2). More preferably, m is set such that the noise determination threshold Thn falls within a range of Dd/3 or more and St/4 or less (Dd/3 ≤ Thn ≤ St/4). The range of the noise determination threshold Thn is defined from a plurality of samples. In one embodiment, when Dd = 10 [µm] and St = 20 [µm], σ = 0.65 and Thn = 6 × σ (m = 6) is set. For example, the height is obtained from the shadow contour shape using a horizontal plane in which the thickness of the measurement target object WA is half as a height reference surface, and the height is obtained as a length from the reference surface to the optical sectional contour shape by superimposing the shadow contour shape and the optical sectional contour shape in the same manner as described later. Note that, although the shadow contour shape and the noise-removed contour shape are superimposed in the following description, the shadow contour shape and the optical sectional contour shape before the noise removal are superimposed in order to obtain the height in this case. Subsequently, the noise removal processing unit 44A removes, as noise, a portion exceeding the noise determination threshold Thn of the trim TR from the optical sectional contour shape corresponding to the trim TR and measured by the optical sectional contour shape measuring unit 2. Then, the noise removal processing unit 44A interpolates the removed portion by, for example, linear interpolation to generate a noise-removed contour shape.

The contour shape calculating unit 45A obtains the contour shape on the basis of the shadow contour shape measured by the shadow contour shape measuring unit 1 and the optical sectional contour shape measured by the optical sectional contour shape measuring unit 2. In the present embodiment, since the noise removal processing unit 44A is provided, the contour shape calculating unit 45A obtains the contour shape on the basis of the shadow contour shape measured by the shadow contour shape measuring unit 1 and the noise-removed contour shape obtained by the noise removal processing unit 44A from the optical sectional contour shape measured by the optical sectional contour shape measuring unit 2.

More specifically, for example, as illustrated in FIG. 6A, the contour shape calculating unit 45A first extracts (reads), from the storage unit 8A, the shadow contour shape α measured by the shadow contour shape measuring unit 1 and the optical sectional contour shape (noise-removed contour shape in the present embodiment) β (β1, β2) measured by the optical sectional contour shape measuring unit 2 at the same measurement point on the basis of the positional relationship information, and performs alignment as illustrated in FIG. 6B, thereby superimposing the shadow contour shape α and the optical sectional contour shape β. For example, as illustrated in FIG. 6A, the alignment is performed by detecting a step position xα from the shadow contour shape α, detecting a step position xβ from the optical sectional contour shape β, and matching the step position xα and the step position xβ. The step position xα is scanned from the inside along the radial direction, and is detected as a portion where the height represented by the shadow contour shape α is first lowered by a preset determination threshold or more. The step position xβ is scanned from the inside along the radial direction, and is detected as a portion where the height represented by the optical sectional contour shape β is first lowered.

Then, the contour shape calculating unit 45A compares a blur amount included in the measurement by the shadow contour shape measuring unit 1 with the height of the step measured by the optical sectional contour shape measuring unit 2 in a predetermined range including the step, and selects one of the shadow contour shape measured by the shadow contour shape measuring unit 1 and the optical sectional contour shape measured by the optical sectional contour shape measuring unit 2 according to the comparison result to obtain the contour shape. The predetermined range including the step is, for example, a range from the step to a predetermined distance (for example, one time or two times the height of the step) set in advance radially outward.

The portion where the measurement accuracy decreases in the contour shape of the beveled measurement target object WA is mainly a step portion where scattering of light or the like occurs, for example. Therefore, in order to reduce the processing time, the measurement result used when obtaining the contour shape is selected. Here, while the measurement target object WA has a disk shape, the shadow contour shape measuring unit 1 measures the shadow contour shape on the basis of the shadow image obtained by imaging the shadow of the peripheral edge portion generated by applying light onto the peripheral edge portion from the tangential direction of the outer periphery. Therefore, in a case where the measurement target object WA is focused on the tip portion of the measurement target object WA even if the depth of field is deepened, a shadow image having a clear shape is obtained at the tip portion of the measurement target object WA, and a shadow image in which blurring occurs in the shape is obtained as the distance from the tip portion increases along the radial direction. Therefore, a function f(x) = y representing a blur amount y monotonously increasing according to the distance x from the tip end position or the start position of the beveling is obtained (estimated) from a plurality of samples in advance, the difference in average height before and after the step is obtained as the height h of the step, and the contour shape calculating unit 45A uses the optical sectional contour shape in a predetermined range including the step position xs as the contour shape in the predetermined range when the blur amount y = f(xs) at the step position xs is larger than the height h of the step at the step position xs measured by the optical sectional contour shape measuring unit 2 (y > h), for example, uses the shadow contour shape in the predetermined range as the contour shape in the predetermined range when the blur amount y = f(xs) is not larger than the height h of the step (when the blur amount y = f(xs) is equal to or less than the height h of the step, y ≤ h), and uses the shadow contour shape as the contour shape in a range excluding the predetermined range for each step. As a result, a final contour shape is obtained.

The contour shape calculating unit 45A obtains each final contour shape by executing such processing for each measurement point in the circumferential direction.

In the above description, the blur amount y is obtained as a function of the distance x, but a predetermined constant yc set in advance from a plurality of samples may be used, and the blur amount yc may be compared with the height h of the step. Alternatively, for example, the optical sectional contour shape in a predetermined range including a step may be used as the contour shape in the predetermined range without performing the comparison.

Note that, in the first embodiment, the noise removal processing unit 44A corresponds to an example of a noise removal processing unit that obtains a noise-removed contour shape by removing noise generated in the height direction from the optical contour shape measured by the optical contour shape measuring unit.

The control processing unit 4A, the input unit 5, the output unit 6, the IF unit 7, and the storage unit 8A can be configured by, for example, a desktop computer, a notebook computer, or the like.

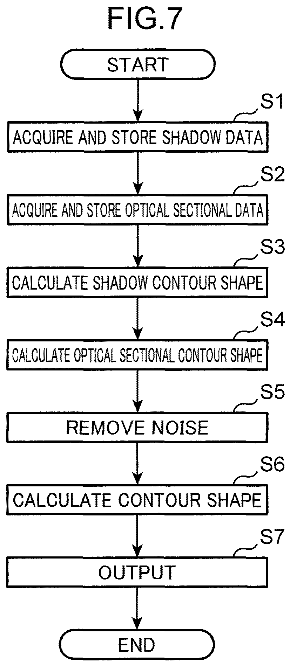

Next, the operation of the present embodiment will be described. FIG. 7 is a flowchart illustrating an operation of the contour shape measuring device according to the first embodiment.

When the contour shape measuring device 1000A having such a configuration is powered on, initialization of necessary units is performed, and the operation is started. In the control processing unit 4A, a control unit 41A, a first shape calculating unit 42 (12), a second shape calculating unit 43 (22), a noise removal processing unit 44, and a contour shape calculating unit 45A are functionally configured by execution of the first control processing program.

When the measurement target object WA is set on the stage 3 and measurement is started, in FIG. 7, first, the contour shape measuring device 1000A causes the control unit 41A of the control processing unit 4A to acquire shadow data measured by the shadow contour shape measuring unit 1 at the measurement position PS1 of the shadow contour shape from the first measuring unit 11 and store the acquired shadow data in the storage unit 8A (S1). The measurement target object WA is sequentially rotated at predetermined angular intervals (sampling intervals) by the stage 3, and each shadow data is acquired at each measurement point (sampling point) in the circumferential direction and stored in association with each measurement point.

Subsequently, the contour shape measuring device 1000A causes the control unit 41A of the control processing unit 4A to acquire the optical sectional data measured by the optical sectional contour shape measuring unit 2 at the measurement position PS2 of the optical sectional contour shape from the second measuring unit 21, and stores the optical sectional data in the storage unit 8A (S2). The measurement target object WA is sequentially rotated at predetermined angular intervals (sampling intervals) by the stage 3, and each optical sectional data is acquired at each measurement point (sampling point) in the circumferential direction and stored in association with each measurement point.

Subsequently, the contour shape measuring device 1000A generates the shadow image data by performing the first image processing on the output (shadow data) of the imaging unit 114 by the first shape calculating unit 42 of the control processing unit 4A, obtains the shadow contour shape by performing the second image processing on the generated shadow image data, and stores the shadow contour shape in the storage unit 8A (S3). For each of the measurement points, each shadow contour shape is obtained and stored in association with each measurement point.

Subsequently, the contour shape measuring device 1000A causes the second shape calculating unit 43 of the control processing unit 4A to obtain the optical sectional contour shape of the output (optical sectional data) of the second measuring unit 21 by processing according to the optical cutting method, and stores the obtained optical sectional contour shape in the storage unit 8A (S4). For each of the measurement points, each optical sectional contour shape is obtained and stored in association with each measurement point.

Subsequently, the contour shape measuring device 1000A causes the noise removal processing unit 44A of the control processing unit 4A to remove noise from the optical sectional contour shape, obtains a noise-removed contour shape, and stores the noise-removed contour shape in the storage unit 8A (S5). For each of the measurement points, each noise-removed contour shape is obtained and stored in association with each measurement point.

Subsequently, the contour shape measuring device 1000A causes the contour shape calculating unit 45A of the control processing unit 4A to obtain a final contour shape, and stores the final contour shape in the storage unit 8A (S6). For each of the measurement points, a final contour shape is obtained and stored in association with each measurement point.

Then, the contour shape measuring device 1000A causes the control unit 41A of the control processing unit 4A to output each contour shape of each measurement point to the output unit 6 (S7), and ends this processing. The contour shapes may be output to an external device via the IF unit 7 as necessary.

As described above, in the contour shape measuring device 1000A according to the first embodiment and the contour shape measuring method mounted on the contour shape measuring device 1000A, in addition to the measurement of the shadow contour shape, the measurement of the optical contour shape and the measurement of the optical sectional contour shape in the first embodiment are performed, and the contour shape is obtained on the basis of the shadow contour shape obtained by the measurement of the shadow contour shape and the optical sectional contour shape obtained by the measurement of the optical sectional contour shape, so that the contour shape can be measured more accurately.

Since the contour shape measuring device 1000A and the contour shape measuring method obtain the contour shape on the basis of the noise-removed contour shape from which noise has been removed, the contour shape can be measured more accurately.

In the trim processing, since cutting is performed with a polishing blade, uncut parts, shavings (dust), and the like may occur, resulting in noise of a contour shape. Since such an uncut part or shavings vary depending on the measurement target object, if it is determined whether the noise is generated with a threshold of a predetermined constant value, there is a possibility that the noise cannot be appropriately determined. Since the contour shape measuring device 1000A and the contour shape measuring method use the noise determination threshold Thn according to the variation in height, noise can be removed more appropriately, and thus the contour shape can be measured more accurately. Since the noise determination threshold Thn is obtained for each trim TR, the contour shape measuring device 1000A and the contour shape measuring method can more appropriately remove noise, and thus can more accurately measure the contour shape.

Since the contour shape measuring device 1000A and the contour shape measuring method use the noise determination threshold Thn according to the variation in height, noise can be removed more appropriately, and thus the contour shape can be measured more accurately.

Next, another embodiment will be described.

### (Second Embodiment)

In the first embodiment, the optical sectional contour shape measuring unit 2 is used as the optical contour shape measuring unit, but in the second embodiment, a confocal contour shape measuring unit 9 is used as the optical contour shape measuring unit. That is, the contour shape measuring device according to the second embodiment includes a shadow contour shape measuring unit, a confocal contour shape measuring unit, and a contour shape calculating unit similar to those described above. The confocal contour shape measuring unit measures the contour shape of the peripheral edge portion as a confocal contour shape from a surface direction by a confocal method. The contour shape calculating unit according to the second embodiment obtains the contour shape on the basis of the shadow contour shape measured by the shadow contour shape measuring unit and the confocal contour shape measured by the confocal contour shape measuring unit. Hereinafter, a description will be given more specifically.

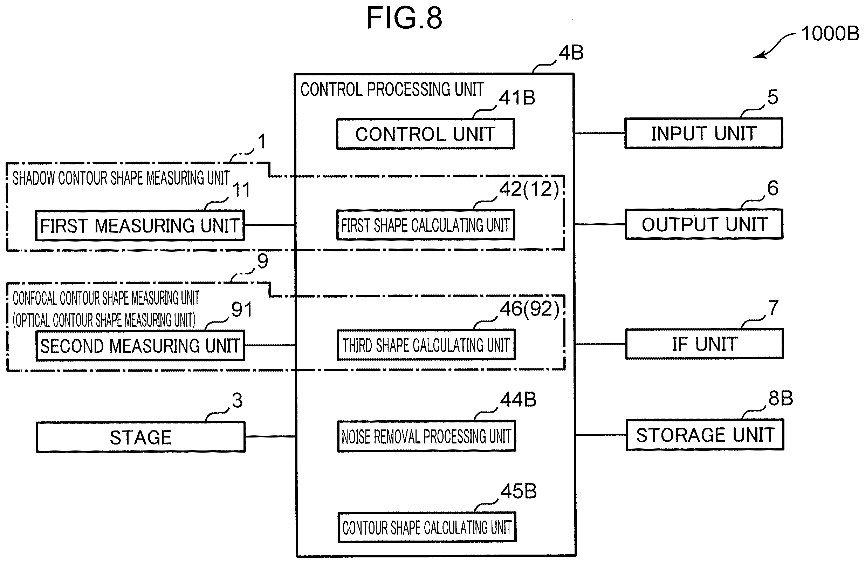

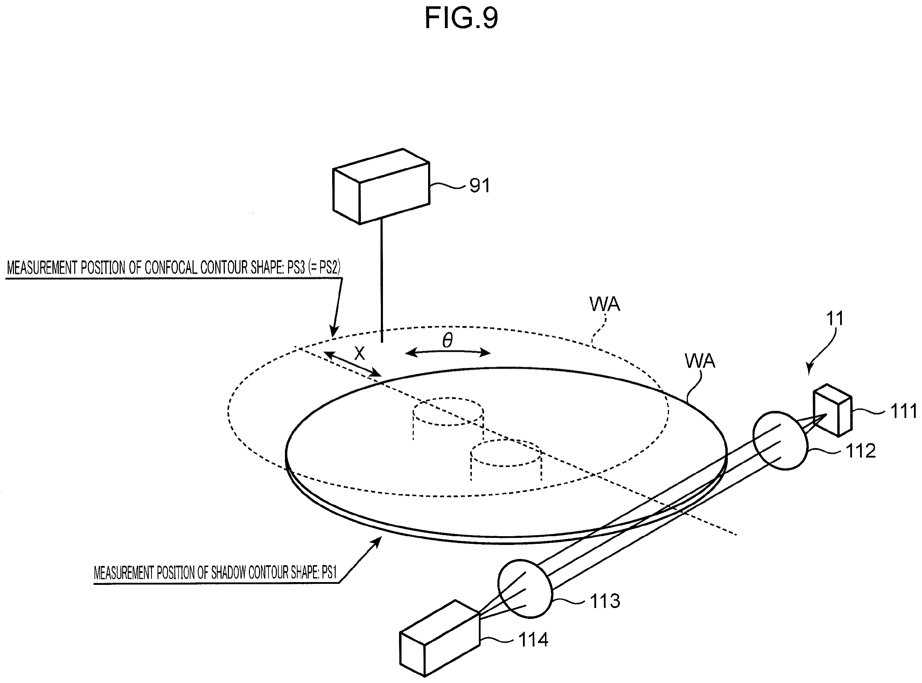

FIG. 8 is a block diagram illustrating a configuration of the contour shape measuring device according to the second embodiment. FIG. 9 is a schematic diagram for explaining a measurement system in the contour shape measuring device of the second embodiment.

For example, as illustrated in FIGS. 8 and 9, a contour shape measuring device 1000B according to the second embodiment includes a shadow contour shape measuring unit 1, a confocal contour shape measuring unit 9, a stage 3, a control processing unit 4B, an input unit 5, an output unit 6, an interface unit (IF unit) 7, and a storage unit 8B. Since the shadow contour shape measuring unit 1, the stage 3, the input unit 5, the output unit 6, and the IF unit 7 in the contour shape measuring device 1000B according to the second embodiment are similar to the shadow contour shape measuring unit 1, the stage 3, the input unit 5, the output unit 6, and the IF unit 7 in the contour shape measuring device 1000A according to the first embodiment, respectively, the description thereof will be omitted.

The confocal contour shape measuring unit 9 is a device that measures the contour shape of the peripheral edge portion of the measurement target object WA as a confocal contour shape from a surface direction by a confocal method. The confocal contour shape measuring unit 9 sequentially rotates the measurement target object WA at the predetermined angular interval (the sampling interval) by the stage 3, and measures each confocal contour shape (each outer contour shape (outer contour shape on the irradiation side of the illumination light) of the cross section along each radial direction of each measurement point) viewed from the side at each measurement point (the sampling point) in the circumferential direction. The confocal contour shape measuring unit 9 includes, for example, a third measuring unit 91 and a third shape calculating unit 92 (46). The third measuring unit 91 is a device that is connected to the control processing unit 4B, condenses and emits illumination light at one point under the control of the control processing unit 4B, and receives reflected light of the illumination light reflected by the measurement target object WA, and is movable along the height direction (thickness direction) of the measurement target object WA. For example, the third measuring unit 91 includes a confocal measuring unit that condenses and emits illumination light at one point and receives reflected light of the illumination light reflected by the measurement target object WA, a rod-like (rod-shaped) support member that is erected along a height direction of the measurement target object WA and includes, for example, a rack, and a scanning drive unit that includes a pinion and an actuator such as a servo motor for rotating the pinion and movably supports the confocal measuring unit along the support member by a rack and pinion. The scanning drive unit is connected to the control processing unit 4B and controlled by the control processing unit 4B. In the confocal method, the distance to the measurement target object WA is obtained using a confocal principle that the amount of reflected light is maximized when the object is focused. More specifically, the confocal measuring unit includes a monochromatic light source (for example, a laser light source or the like) that emits monochromatic light, an image forming optical system that forms an image of the monochromatic light from the monochromatic light source at a fixed focal point and irradiates the measurement target object WA with the monochromatic light, a pinhole member in which a pinhole (fine opening) is formed, and a light receiving unit that receives the monochromatic light reflected by the measurement target object WA through the pinhole of the pinhole member. In the present embodiment, the third shape calculating unit 92 (46) is functionally configured in the control processing unit 4B as described later, and obtains the contour shape of the peripheral edge portion in the measurement target object WA as the confocal contour shape by processing the output of the third measuring unit 91 according to the confocal method. More specifically, the third shape calculating unit 92 (46) controls the scanning drive unit to scan the confocal measuring unit along the height direction of the measurement target object WA, and obtains the position of the confocal measuring unit at which the amount of light of the reflected light received by the light receiving unit is maximized on the basis of the output of the light receiving unit, thereby obtaining the distance from the confocal measuring unit to the surface of the measurement target object WA. Since the confocal measuring unit has a fixed focus, when the surface of the measurement target object WA is not focused (not in focus), blurring occurs, the reflected light is substantially blocked by the pinhole, the reflected light is received by the light receiving unit near the focus, and when the surface of the measurement target object WA is focused (in focus), the reflected light is received by the light receiving unit with the maximum amount of light. Accordingly, the distance is obtained. The third shape calculating unit 92 (46) obtains the confocal contour shape by repeating such distance measurement at predetermined intervals along the radial direction of the measurement target object WA. The movement of the measurement target object WA along the radial direction is performed by moving the drive unit 32 in the stage 3 in the horizontal direction.

Note that, in the above description, the confocal measuring unit may include a slit instead of the pinhole. As a result, the movement of the measurement target object WA in the radial direction for obtaining the confocal contour shape can be omitted, and the measurement time can be shortened. Furthermore, in the above description, the confocal measuring unit may include a multicolor light source that emits multicolor light (each light including a plurality of wavelengths different from each other) instead of the monochromatic light source, include an image forming optical system having chromatic aberration so as to have a focal length different for each of the plurality of wavelengths instead of the image forming optical system, include the light receiving unit for each of the plurality of wavelengths, further include a spectroscopic unit that disperses reflected light to the plurality of wavelengths, and receive each light of the plurality of wavelengths emitted from the spectroscopic unit by each of the plurality of light receiving units. As a result, the scanning of the confocal measuring unit can be omitted along the height direction of the measurement target object WA, and the measurement time can be shortened.

In the second embodiment, as described above, the confocal contour shape measuring unit 9 corresponds to another example of the optical contour shape measuring unit that measures the contour shape of the peripheral edge portion as the optical contour shape by measuring the distance to the measurement target object using light from the surface direction. Similarly to the above, the predetermined reference surface is, for example, a horizontal plane in which the thickness of the measurement target object WA is halved from the shadow contour shape, and the height is obtained as a length from the reference surface to the confocal contour shape by superimposing the shadow contour shape and the confocal contour shape in the same manner as described later.

As illustrated in FIG. 9, the third measuring unit 91 and the stage 3 are disposed such that, when the measurement target object WA is moved to a measurement position PS3 of the confocal contour shape by the stage 3, the peripheral edge portion of the measurement target object WA is illuminated by the illumination light in the third measuring unit 91 and receives the reflected light. The measurement position PS3 of the confocal contour shape is a position of the measurement target object WA when the confocal contour shape measuring unit 9 measures the confocal contour shape, and is the measurement position PS2 of the optical sectional contour shape in the present embodiment (PS3 = PS2). The first measuring unit 11 of the shadow contour shape measuring unit 1, the third measuring unit 91 of the confocal contour shape measuring unit 9, and the stage 3 are disposed and fixed as described above.

Then, the predetermined movement range when the drive unit 32 in the stage 3 is moved in the horizontal direction is defined such that, for example, when the drive unit 32 moves to one end, the measurement target object WA is located at the measurement position PS1 of the shadow contour shape as illustrated in FIG. 9, and when the drive unit 32 moves to the other end, the measurement target object WA is located at the measurement position PS3 of the confocal contour shape.

The storage unit 8B is a circuit that is connected to the control processing unit 4B and stores various predetermined programs and various predetermined data under the control of the control processing unit 4B. The various predetermined programs include, for example, a second control processing program, and the second control processing program includes, for example, a second control program, a first shape calculation program similar to that of the first embodiment, a third shape calculation program, a noise removal processing program, a second contour shape calculation program, and the like. The second control program is a program for controlling each of the units 1 to 3, 5 to 7, and 8B of the contour shape measuring device 1000B according to the function of each unit. The third shape calculation program is a program for obtaining the contour shape of the peripheral edge portion in the measurement target object WA as a confocal contour shape by processing the output of the third measuring unit 91 according to the confocal method. The noise removal program is a program for removing noise generated in the height direction from the confocal contour shape measured by the confocal contour shape measurement program to obtain a noise-removed contour shape. The second contour shape calculation program is a program for obtaining the contour shape on the basis of the shadow contour shape obtained by the shadow contour shape measurement program and the confocal contour shape obtained by the third shape calculation program of the confocal contour shape measurement program.

The various types of predetermined data include, for example, data necessary for executing these programs, such as a measurement target object name, positional relationship information, each data during information processing, a contour shape, and the like. The positional relationship information is information indicating a positional relationship between a measurement position (first measurement position) of the first measuring unit 11 in the shadow contour shape measuring unit 1 and a measurement position (third measurement position) of the third measuring unit 91 in the confocal contour shape measuring unit 9. Since the shadow contour shape measuring unit 1, the confocal contour shape measuring unit 9, and the stage 3 are fixedly disposed as described above, the positional relationship between the first measurement position and the third measurement position can be defined in advance, and from the positional relationship information, the shadow contour shape and the confocal contour shape at each measurement point can be made to correspond to each other for each measurement point.

Such a storage unit 8B includes, for example, a ROM, an EEPROM, a RAM, and the like, and may include a hard disk device as necessary.

The control processing unit 4B is a circuit for controlling each of the units 1 to 3, 5 to 7, and 8B of the contour shape measuring device 1000B according to the function of each unit to obtain the contour shape of the measurement target object WA. The control processing unit 4B includes, for example, a CPU and its peripheral circuits. In the control processing unit 4B, a control unit 41B, a first shape calculating unit 42 (12), a third shape calculating unit 46 (92), a noise removal processing unit 44B, and a contour shape calculating unit 45B are functionally configured by executing the second control processing program. Since the first shape calculating unit 42 (12) in the second embodiment is similar to the first shape calculating unit 42 (12) in the first embodiment, the description thereof will be omitted.

The control unit 41B controls each of the units 1 to 3, 5 to 7, and 8B of the contour shape measuring device 1000B according to the function of each unit, and controls the entire contour shape measuring device 1000B.

As described above, the third shape calculating unit 46 (92) obtains the contour shape of the peripheral edge portion in the measurement target object WA as the confocal contour shape by processing the output of the third measuring unit 91 according to the confocal method. For each of the measurement points, a confocal contour shape of the measurement point is generated.

The noise removal processing unit 44B removes noise generated in the height direction from the confocal contour shape measured by the confocal contour shape measuring unit 9 to obtain a noise-removed contour shape. More specifically, the noise removal processing unit 44B can be configured by replacing the optical sectional contour shape measuring unit 2 with the confocal contour shape measuring unit 9 and replacing the optical sectional contour shape with the confocal contour shape in the noise removal processing unit 44A described above.

The contour shape calculating unit 45B obtains the contour shape on the basis of the shadow contour shape measured by the shadow contour shape measuring unit 1 and the confocal contour shape measured by the confocal contour shape measuring unit 9. In the present embodiment, since the noise removal processing unit 44B is provided, the contour shape calculating unit 45B obtains the contour shape on the basis of the shadow contour shape measured by the shadow contour shape measuring unit 1 and the noise-removed contour shape obtained by the noise removal processing unit 44B from the confocal sectional contour shape measured by the confocal contour shape measuring unit 9.

More specifically, the contour shape calculating unit 45B extracts (reads) the shadow contour shape measured by the shadow contour shape measuring unit 1 and the confocal contour shape (the noise-removed contour shape in the present embodiment) measured by the confocal contour shape measuring unit 9 at the same measurement point on the basis of the positional relationship information from the storage unit 8B, and performs alignment to superimpose the shadow contour shape and the confocal contour shape. The alignment is similar to that of the first embodiment, and for example, a step position is detected from the shadow contour shape, a step position is detected from the confocal contour shape, and these step positions are matched with each other. Then, the contour shape calculating unit 45B divides a predetermined measurement range including the step and for obtaining the contour shape of the peripheral edge portion into a plurality of sections, and obtains the contour shape of the peripheral edge portion by selecting one of the shadow contour shape and the confocal contour shape (the noise-removed contour shape in the present embodiment) for each of the plurality of sections. In the selection, for example, when both the shadow contour shape and the confocal contour shape exist in the section, the confocal contour shape is selected, and when the shadow contour shape exists and the confocal contour shape does not exist, the shadow contour shape is selected. Note that a case where the confocal contour shape exists in a part of the section is regarded as a case where the confocal contour shape does not exist in the section. By shortening the length of the section, such a case considered is reduced.

Note that, in the second embodiment, the noise removal processing unit 44B corresponds to another example of a noise removal processing unit that obtains a noise-removed contour shape by removing noise generated in the height direction from the optical contour shape measured by the optical contour shape measuring unit.

The control processing unit 4B, the input unit 5, the output unit 6, the IF unit 7, and the storage unit 8B can be configured by, for example, a desktop computer, a notebook computer, or the like.

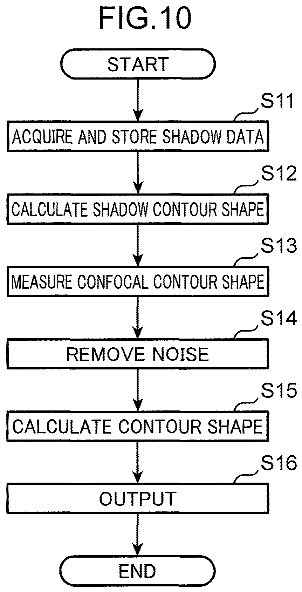

Next, the operation of the present embodiment will be described. FIG. 10 is a flowchart illustrating an operation of the contour shape measuring device according to the second embodiment.

When the contour shape measuring device 1000B having such a configuration is powered on, initialization of necessary units is performed, and the operation is started. In the control processing unit 4B, a control unit 41B, a first shape calculating unit 42 (12), a third shape calculating unit 46 (92), and a contour shape calculating unit 45B are functionally configured by execution of the second control processing program.

When the measurement target object WA is set on the stage 3 and the measurement is started, in FIG. 10, first, the contour shape measuring device 1000B causes the control unit 41B of the control processing unit 4B to execute a process S11 similar to the process S1 of the first embodiment, and then causes the first shape calculating unit 42 (12) of the control processing unit 4B to execute a process S12 similar to the process S3 of the first embodiment.

Subsequently, the contour shape measuring device 1000B obtains the contour shape of the peripheral edge portion in the measurement target object WA as the confocal contour shape by the confocal contour shape measuring unit 9 by processing the output of the third measuring unit 91 according to the confocal method at the measurement position PS3 (= PS2) of the confocal contour shape and stores the confocal contour shape in the storage unit 8B (S13). The measurement target object WA is sequentially rotated at the predetermined angular interval (the sampling interval) by the stage 3, and each confocal contour shape is measured at each measurement point (the sampling point) in the circumferential direction and stored in association with each measurement point.

Subsequently, the contour shape measuring device 1000B causes the noise removal processing unit 44B of the control processing unit 4B to remove noise from the optical sectional contour shape, obtains a noise-removed contour shape, and stores the noise-removed contour shape in the storage unit 8B (S14). For each of the measurement points, each noise-removed contour shape is obtained and stored in association with each measurement point.

Subsequently, the contour shape measuring device 1000B causes the contour shape calculating unit 45B of the control processing unit 4B to obtain a final contour shape, and stores the final contour shape in the storage unit 8B (S15). For each of the measurement points, a final contour shape is obtained and stored in association with each measurement point.

Then, the contour shape measuring device 1000B causes the control unit 41B of the control processing unit 4B to output each contour shape of each measurement point to the output unit 6 (S16), and ends this processing. The contour shapes may be output to an external device via the IF unit 7 as necessary.

As described above, in the contour shape measuring device 1000B according to the second embodiment and the contour shape measuring method mounted on the contour shape measuring device 1000B, in addition to the measurement of the shadow contour shape, the measurement of the optical contour shape and the measurement of the confocal contour shape in the second embodiment are performed, and the contour shape is obtained on the basis of the shadow contour shape obtained by the measurement of the shadow contour shape and the confocal contour shape obtained by the measurement of the confocal contour shape, so that the contour shape can be measured more accurately.

Next, another embodiment will be described.

### (Third Embodiment)

In the first embodiment, the optical sectional contour shape measuring unit 2 is used as the optical contour shape measuring unit, and in the second embodiment, the confocal contour shape measuring unit 9 is used as the optical contour shape measuring unit. However, in the third embodiment, the optical sectional contour shape measuring unit 2 and the confocal contour shape measuring unit 9 are used as the optical contour shape measuring unit. That is, the contour shape measuring device according to the third embodiment includes a shadow contour shape measuring unit, an optical sectional contour shape measuring unit, a confocal contour shape measuring unit, and a contour shape calculating unit similar to those described above. The optical sectional contour shape measuring unit according to the third embodiment measures the contour shape of the peripheral edge portion as an optical sectional contour shape by an optical cutting method from a surface direction of one surface of a measurement target object, among one surface and the other surface facing the one surface. The confocal contour shape measuring unit according to the third embodiment measures the contour shape of the peripheral edge portion as a confocal contour shape from a surface direction of the other surface by a confocal method. The contour shape calculating unit according to the third embodiment obtains the contour shape on the one surface on the basis of the shadow contour shape measured by the shadow contour shape measuring unit and the optical sectional contour shape measured by the optical sectional contour shape measuring unit, and obtains the contour shape on the other surface on the basis of the shadow contour shape measured by the shadow contour shape measuring unit and the confocal contour shape measured by the confocal contour shape measuring unit. Hereinafter, a description will be given more specifically.

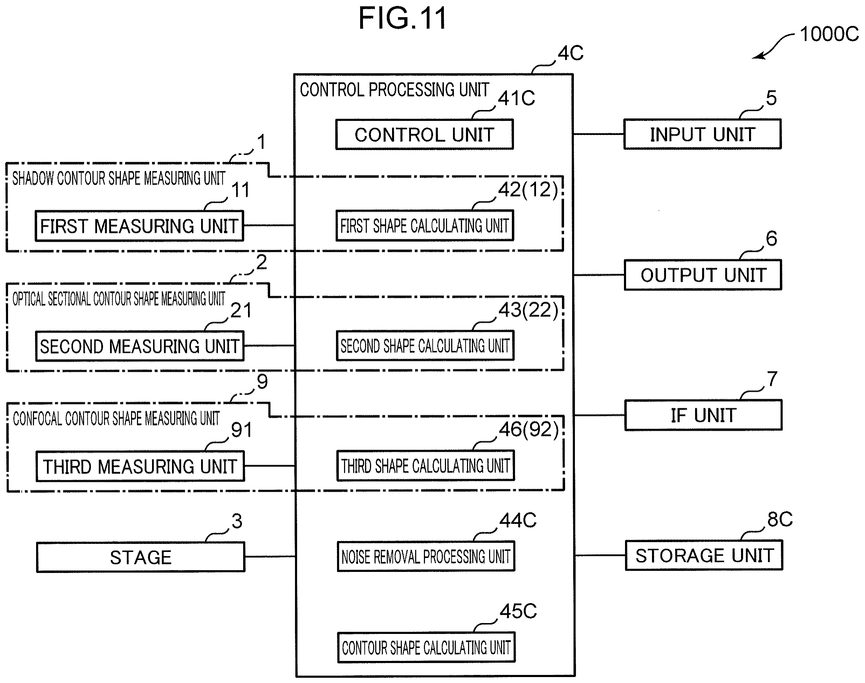

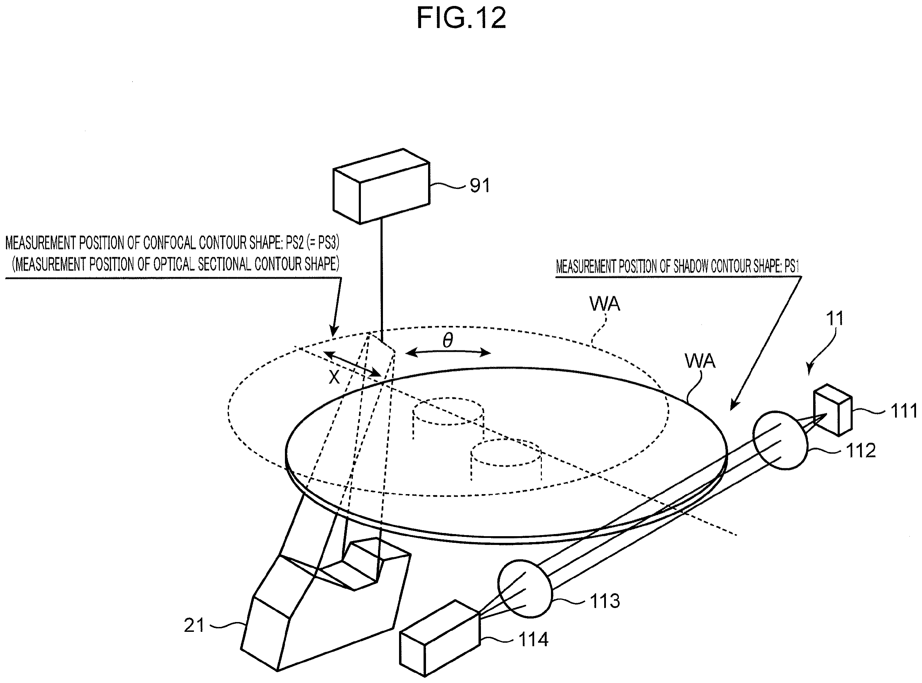

FIG. 11 is a block diagram illustrating a configuration of the contour shape measuring device according to the third embodiment. FIG. 12 is a schematic diagram for explaining a measurement system in the contour shape measuring device of the third embodiment.

For example, as illustrated in FIGS. 11 and 12, a contour shape measuring device 1000C according to the third embodiment includes a shadow contour shape measuring unit 1, an optical sectional contour shape measuring unit 2, a confocal contour shape measuring unit 9, a stage 3, a control processing unit 4C, an input unit 5, an output unit 6, an interface unit (IF unit) 7, and a storage unit 8C. Since the shadow contour shape measuring unit 1, the optical sectional contour shape measuring unit 2, the stage 3, the input unit 5, the output unit 6, and the IF unit 7 in the contour shape measuring device 1000C according to the third embodiment are similar to the shadow contour shape measuring unit 1, the optical sectional contour shape measuring unit 2, the stage 3, the input unit 5, the output unit 6, and the IF unit 7 in the contour shape measuring device 1000A according to the first embodiment, respectively, the description thereof will be omitted. Since the confocal contour shape measuring unit 9 in the contour shape measuring device 1000C of the third embodiment is similar to the confocal contour shape measuring unit 9 in the contour shape measuring device 1000B of the second embodiment, the description thereof will be omitted.

In the third embodiment, as described above, the optical sectional contour shape measuring unit 2 and the confocal contour shape measuring unit 9 correspond to another example of the optical contour shape measuring unit that measures the contour shape of the peripheral edge portion as the optical contour shape by measuring the distance to the measurement target object using light from the surface direction.

As illustrated in FIG. 12, the second measuring unit 21 and the stage 3 are disposed such that, when the measurement target object WA is moved to the measurement position PS2 (= PS3) of the optical sectional contour shape by the stage 3, the extending direction of the slit-shaped illumination light in the second measuring unit 21 (the direction in which the illumination light extends in the slit shape) coincides with the radial direction X of the measurement target object WA, and the peripheral edge portion of the measurement target object WA is illuminated with the slit-shaped illumination light in the second measuring unit 21 on one surface of the measurement target object WA, among one surface (one main surface) and the other surface (the other main surface) facing the one surface, for example, on the back surface of the measurement target object WA in the example illustrated in FIG. 12. As illustrated in FIG. 12, the third measuring unit 91 and the stage 3 are disposed such that, when the measurement target object WA is moved to the measurement position PS3 (= PS2) of the confocal contour shape by the stage 3, the peripheral edge portion of the measurement target object WA is illuminated with the illumination light in the third measuring unit 91 and receives the reflected light on the other surface of the measurement target object WA, for example, the surface of the measurement target object WA in the example illustrated in FIG. 12. The first measuring unit 11 of the shadow contour shape measuring unit 1, the second measuring unit 21 of the optical sectional contour shape measuring unit 2, the third measuring unit 91 of the confocal contour shape measuring unit 9, and the stage 3 are disposed and fixed as described above.

Then, the predetermined movement range when the drive unit 32 in the stage 3 is moved in the horizontal direction is defined such that, for example, when the drive unit 32 moves to one end, the measurement target object WA is located at the measurement position PS1 of the shadow contour shape as illustrated in FIG. 12, and when the drive unit 32 moves to the other end, the measurement target object WA is located at the measurement position PS3 (= PS2) of the confocal contour shape.

The storage unit 8C is a circuit that is connected to the control processing unit 4C and stores various predetermined programs and various predetermined data under the control of the control processing unit 4C. The various predetermined programs include, for example, a third control processing program, and the third control processing program includes, for example, a third control program, first and second shape calculation programs similar to that of the first embodiment, a third shape calculation program similar to the second embodiment, a noise removal processing program, a third contour shape calculation program, and the like. The third control program is a program for controlling each of the units 1 to 3, 5 to 7, and 8C of the contour shape measuring device 1000C according to the function of each unit. The noise removal processing program is a program for obtaining a first noise-removed contour shape by removing noise generated in a height direction from an optical sectional contour shape measured by an optical sectional contour shape measurement program, and obtaining a second noise-removed contour shape by removing noise generated in the height direction from a confocal contour shape measured by a confocal contour shape measurement program. The third contour shape calculation program is a program for obtaining a contour shape in the one surface on the basis of a shadow contour shape obtained by the first shape calculation program of a shadow contour shape measurement program and an optical sectional contour shape obtained by the second shape calculation program of an optical sectional contour shape measurement program, and obtaining a contour shape in the other surface on the basis of the shadow contour shape and a confocal contour shape obtained by a third shape calculation program of a confocal contour shape measurement program.

The various types of predetermined data include, for example, data necessary for executing these programs, such as a measurement target object name, positional relationship information, each data during information processing, a contour shape, and the like. The positional relationship information is information indicating a positional relationship among a measurement position (first measurement position) of the first measuring unit 11 in the shadow contour shape measuring unit 1, a measurement position (second measurement position) of the second measuring unit 21 in the optical sectional contour shape measuring unit 2, and a measurement position (third measurement position) of the third measuring unit 91 in the confocal contour shape measuring unit 9. Since the shadow contour shape measuring unit 1, the optical sectional contour shape measuring unit 2, the confocal contour shape measuring unit 9, and the stage 3 are fixedly disposed as described above, the positional relationship among the first measurement position, the second measurement position, and the third measurement position can be defined in advance, and from the positional relationship information, the shadow contour shape, the optical sectional contour shape, and the confocal contour shape at each measurement point can be made to correspond to each other for each measurement point.

Such a storage unit 8C includes, for example, a ROM, an EEPROM, a RAM, and the like, and may be configured to include a hard disk device as necessary.

The control processing unit 4C is a circuit for controlling each of the units 1 to 3, 5 to 7, and 8C of the contour shape measuring device 1000C according to the function of each unit to obtain the contour shape of the measurement target object WA. The control processing unit 4C includes, for example, a CPU and its peripheral circuits. In the control processing unit 4C, a control unit 41C, a first shape calculating unit 42 (12), the second shape calculating unit 43 (22), a third shape calculating unit 46 (92), a noise removal processing unit 44C, and a contour shape calculating unit 45C are functionally configured by executing the third control processing program. Since the first shape calculating unit 42 (12) in the third embodiment is similar to the first shape calculating unit 42 (12) in the first embodiment, the description thereof will be omitted. The second shape calculating unit 43 (22) in the third embodiment is similar to the second shape calculating unit 43 (22) in the first embodiment except that the contour shape of the peripheral edge portion in one surface (the back surface in the example illustrated in FIG. 12) of the measurement target object WA is obtained, and thus the description thereof will be omitted. The third shape calculating unit 46 (92) in the third embodiment is similar to the third shape calculating unit 46 (92) in the second embodiment except that the contour shape of the peripheral edge portion in the other surface (the front surface in the example illustrated in FIG. 12) of the measurement target object WA is obtained, and thus the description thereof will be omitted.

The control unit 41C controls each of the units 1 to 3, 5 to 7, and 8C of the contour shape measuring device 1000C according to the function of each unit, and controls the entire contour shape measuring device 1000C.

The noise removal processing unit 44C removes noise generated in the height direction from the optical sectional contour shape measured by the optical sectional contour shape measuring unit 2 to obtain a first noise-removed contour shape in the one surface, and removes noise generated in the height direction from the confocal contour shape measured by the confocal contour shape measuring unit 9 to obtain a second noise-removed contour shape in the other surface. Since the noise removal processing unit 44C obtains the first noise-removed contour shape in the one surface by processing similar to that of the noise removal processing unit 44A in the first embodiment, the description thereof will be omitted. Since the noise removal processing unit 44C obtains the second noise-removed contour shape on the other surface by processing similar to that of the noise removal processing unit 44B in the second embodiment, the description thereof will be omitted.

The contour shape calculating unit 45C obtains a contour shape on the one surface on the basis of the shadow contour shape measured by the shadow contour shape measuring unit 1 and the optical sectional contour shape measured by the optical sectional contour shape measuring unit 2, and obtains a contour shape on the other surface on the basis of the shadow contour shape measured by the shadow contour shape measuring unit 1 and the confocal contour shape measured by the confocal contour shape measuring unit 9. More specifically, the contour shape calculating unit 45C obtains the contour shape on the basis of the shadow contour shape measured by the shadow contour shape measuring unit 1, the first noise-removed contour shape obtained by the noise removal processing unit from the optical sectional contour shape measured by the optical sectional contour shape measuring unit 2, and the second noise-removed contour shape obtained by the noise removal processing unit from the confocal contour shape measured by the confocal contour shape measuring unit 9. Since the contour shape calculating unit 45C obtains the contour shape in the one surface on the basis of the shadow contour shape measured by the shadow contour shape measuring unit 1 and the optical sectional contour shape measured by the optical sectional contour shape measuring unit 2 by processing similar to that of the contour shape calculating unit 45A in the first embodiment, the description thereof will be omitted. Since the contour shape calculating unit 45C obtains the contour shape on the other surface on the basis of the shadow contour shape measured by the shadow contour shape measuring unit 1 and the confocal contour shape measured by the confocal contour shape measuring unit 9 by processing similar to that of the contour shape calculating unit 45B in the second embodiment, the description thereof will be omitted. The contour shape calculating unit 45C may obtain the contour shape of the peripheral edge portion in the measurement target object WA by integrating the obtained contour shape of the one surface and the obtained contour shape of the other surface by using the contour shape of the tip portion in the measurement target object WA.

Note that, in the third embodiment, the noise removal processing unit 44C corresponds to an example of a noise removal processing unit that obtains a noise-removed contour shape by removing noise generated in the height direction from the optical contour shape measured by the optical contour shape measuring unit.

The control processing unit 4C, the input unit 5, the output unit 6, the IF unit 7, and the storage unit 8C can be configured by, for example, a desktop computer, a notebook computer, or the like.

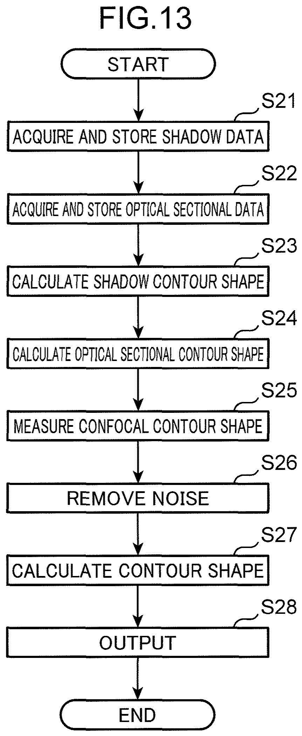

Next, the operation of the present embodiment will be described. FIG. 13 is a flowchart illustrating an operation of the contour shape measuring device according to the third embodiment.

When the contour shape measuring device 1000C having such a configuration is powered on, initialization of necessary units is performed, and the operation is started. In the control processing unit 4C, a control unit 41C, a first shape calculating unit 42 (12), a second shape calculating unit 43 (22), a third shape calculating unit 46 (92), a noise removal processing unit 44C, and a contour shape calculating unit 45C are functionally configured by execution of the third control processing program.

When the measurement target object WA is set on the stage 3 and the measurement is started, in FIG. 13, first, the contour shape measuring device 1000C causes the control unit 41C of the control processing unit 4C to execute a process S21 similar to the process S1 of the first embodiment, subsequently causes the control unit 41C of the control processing unit 4C to execute a process S22 similar to the process S2 of the first embodiment on one surface of the measurement target object WA, subsequently causes the first shape calculating unit 42 (12) of the control processing unit 4C to execute a process S23 similar to the process S3 of the first embodiment, subsequently causes the second shape calculating unit 43 (22) of the control processing unit 4C to execute a process S24 similar to the process S4 of the first embodiment on one surface of the measurement target object WA, and subsequently, causes the third shape calculating unit 46 (92) of the control processing unit 4C to execute a process S25 similar to the process S13 of the second embodiment on the other surface of the measurement target object WA.

Subsequently, the contour shape measuring device 1000C causes the noise removal processing unit 44C of the control processing unit 4C to execute a process S26 similar to the process S5 of the first embodiment on one surface of the measurement target object WA, and to execute a process S26 similar to the process S14 of the second embodiment on the other surface of the measurement target object WA.

Subsequently, the contour shape measuring device 1000C causes the contour shape calculating unit 45C of the control processing unit 4C to obtain a final contour shape and stores the final contour shape in the storage unit 8C (S27). For each of the measurement points, a final contour shape is obtained and stored in association with each measurement point.

Then, the contour shape measuring device 1000C causes the control unit 41C of the control processing unit 4C to output each contour shape of each measurement point to the output unit 6 (S28), and ends this processing. The contour shapes may be output to an external device via the IF unit 7 as necessary.

Note that, in the example illustrated in FIG. 12, the contour shape measuring device 1000C is configured to measure the contour shape of the peripheral edge portion on the surface of the measurement target object WA by the confocal contour shape measuring unit 9 and measure the contour shape of the peripheral edge portion on the back surface of the measurement target object WA by the optical sectional contour shape measuring unit 2. However, the contour shape measuring device 1000C may be configured to measure the contour shape of the peripheral edge portion on the back surface of the measurement target object WA by the confocal contour shape measuring unit 9 and measure the contour shape of the peripheral edge portion on the surface of the measurement target object WA by the optical sectional contour shape measuring unit 2. Such a contour shape measuring device can be substantially realized by the configuration of the contour shape measuring device 1000C illustrated in FIG. 12 by turning over the measurement target object WA placed in contact with the stage 3 on the back surface and placing the measurement target object WA on the stage 3.

As described above, in the contour shape measuring device 1000C according to the third embodiment and the contour shape measuring method mounted on the contour shape measuring device 1000C, in addition to the measurement of the shadow contour shape, the measurement of the optical sectional contour shape for one surface of the measurement target object WA is performed as the measurement of the optical contour shape, and the contour shape in the one surface is obtained on the basis of the shadow contour shape obtained by the measurement of the shadow contour shape and the optical sectional contour shape obtained by the measurement of the optical sectional contour shape. Then, in the contour shape measuring device 1000C and the contour shape measuring method, in addition to the measurement of the shadow contour shape, the measurement of the confocal contour shape on the other surface of the measurement target object WA is performed as the measurement of the optical contour shape, and the contour shape on the other surface is obtained on the basis of the shadow contour shape obtained by the measurement of the shadow contour shape and the confocal contour shape obtained by the measurement of the confocal contour shape. Therefore, the contour shape measuring device 1000C and the contour shape measuring method can more accurately measure the contour shapes of both surfaces in the peripheral edge portion.

In the measurement of each contour shape on both surfaces of the measurement target object WA, an optical cutting method may be used for both the surfaces, or a confocal method may be used for both the surfaces.

The present specification discloses various aspects of techniques as described above, and the main techniques of the disclosed aspects are summarized below.

A contour shape measuring device according to one aspect is a device that measures a contour shape in a disk-shaped measurement target object having a beveled peripheral edge portion, the contour shape measuring device including: a shadow contour shape measuring unit that measures the contour shape as a shadow contour shape on a basis of a shadow image obtained by imaging a shadow of the peripheral edge portion generated by applying light onto the peripheral edge portion from a tangential direction of an outer periphery; an optical contour shape measuring unit that measures the contour shape of the peripheral edge portion as an optical contour shape by measuring a distance to the measurement target object using light from a surface direction; and a contour shape calculating unit that obtains the contour shape on a basis of a shadow contour shape measured by the shadow contour shape measuring unit and an optical contour shape measured by the optical contour shape measuring unit.

Such a contour shape measuring device includes the optical contour shape measuring unit in addition to the shadow contour shape measuring unit, and obtains the contour shape on the basis of the shadow contour shape measured by the shadow contour shape measuring unit and the optical contour shape measured by the optical contour shape measuring unit, so that the contour shape can be measured more accurately.

In another aspect, in the contour shape measuring device described above, the optical contour shape measuring unit is an optical sectional contour shape measuring unit that measures the optical contour shape as an optical sectional contour shape from the surface direction by an optical cutting method.

According to this, it is possible to provide the contour shape measuring device that measures the optical contour shape as the optical sectional contour shape by an optical cutting method.

In another aspect, in the contour shape measuring device described above, the optical contour shape measuring unit is a confocal contour shape measuring unit that measures the optical contour shape as a confocal contour shape by a confocal method.

According to this, it is possible to provide the contour shape measuring device that measures the optical contour shape as the confocal contour shape from the surface direction by a confocal method.

In another aspect, in the contour shape measuring device described above, the optical contour shape measuring unit includes an optical sectional contour shape measuring unit that measures the contour shape of the peripheral edge portion as an optical sectional contour shape by an optical cutting method from a surface direction of one surface of the measurement target object, among one surface and another surface facing the one surface, and a confocal contour shape measuring unit that measures the contour shape of the peripheral edge portion as a confocal contour shape from a surface direction of the other surface by a confocal method, and the contour shape calculating unit obtains a contour shape on the one surface on a basis of a shadow contour shape measured by the shadow contour shape measuring unit and an optical sectional contour shape measured by the optical sectional contour shape measuring unit, and obtains a contour shape on the other surface on a basis of a shadow contour shape measured by the shadow contour shape measuring unit and a confocal contour shape measured by the confocal contour shape measuring unit.

Since such a contour shape measuring device includes the optical sectional contour shape measuring unit on one surface and the confocal contour shape measuring unit on the other surface, the contour shapes of both surfaces in the peripheral edge portion can be measured more accurately.

In another aspect, the contour shape measuring device described above further includes a noise removal processing unit that obtains a noise-removed contour shape by removing noise generated in a height direction from an optical contour shape measured by the optical contour shape measuring unit, in which the contour shape calculating unit obtains the contour shape on a basis of a shadow contour shape measured by the shadow contour shape measuring unit and a noise-removed contour shape obtained by the noise removal processing unit from an optical contour shape measured by the optical contour shape measuring unit. Preferably, in the contour shape measuring device described above, the optical contour shape measuring unit is an optical sectional contour shape measuring unit that measures the optical contour shape as an optical sectional contour shape from the surface direction by an optical cutting method, the noise removal processing unit obtains a noise-removed contour shape by removing noise generated in a height direction from the optical sectional contour shape measured by the optical sectional contour shape measuring unit, and the contour shape calculating unit obtains the contour shape on the basis of the shadow contour shape measured by the shadow contour shape measuring unit and the noise-removed contour shape obtained by the noise removal processing unit from the optical sectional contour shape measured by the optical sectional contour shape measuring unit. Preferably, in the contour shape measuring device described above, the optical contour shape measuring unit is a confocal contour shape measuring unit that measures the optical contour shape as a confocal contour shape by a confocal method, the noise removal processing unit obtains a noise-removed contour shape by removing noise generated in a height direction from the confocal contour shape measured by the confocal contour shape measuring unit, and the contour shape calculating unit obtains the contour shape on the basis of the shadow contour shape measured by the shadow contour shape measuring unit and the noise-removed contour shape obtained by the noise removal processing unit from the confocal contour shape measured by the confocal contour shape measuring unit. Preferably, in the contour shape measuring device described above, the optical contour shape measuring unit includes an optical sectional contour shape measuring unit that measures the contour shape of the peripheral edge portion as an optical sectional contour shape by an optical cutting method from a surface direction of one surface of the measurement target object, among one surface and the other surface facing the one surface, and a confocal contour shape measuring unit that measures the contour shape of the peripheral edge portion as a confocal contour shape by a confocal method from a surface direction of the other surface, the noise removal processing unit obtains a first noise-removed contour shape by removing noise generated in a height direction from an optical sectional contour shape measured by the optical sectional contour shape measuring unit, and obtains a second noise-removed contour shape by removing noise generated in a height direction from the confocal contour shape measured by the confocal contour shape measuring unit, and the contour shape calculating unit obtains the contour shape on the basis of a shadow contour shape measured by the shadow contour shape measuring unit, a first noise-removed contour shape obtained by the noise removal processing unit from an optical sectional contour shape measured by the optical sectional contour shape measuring unit, and a second noise-removed contour shape obtained by the noise removal processing unit from a confocal contour shape measured by the confocal contour shape measuring unit.

Since such a contour shape measuring device obtains the contour shape on the basis of the noise-removed contour shape from which noise has been removed, the contour shape can be measured more accurately.

In another aspect, in the contour shape measuring device described above, the noise removal processing unit removes the noise using a threshold corresponding to a variation in height obtained on a basis of an optical contour shape measured by the optical contour shape measuring unit.

In the trim processing, since cutting is performed with a polishing blade, uncut parts, shavings (dust), and the like may occur, resulting in noise of a contour shape. Since such an uncut part or shavings vary depending on the measurement target object, if it is determined whether the noise is generated with a threshold of a predetermined constant value, there is a possibility that the noise cannot be appropriately determined. Since the contour shape measuring device uses the threshold according to the variation in height, noise can be removed more appropriately, and thus the contour shape can be measured more accurately.

A contour shape measuring method according to another aspect is a method for measuring a contour shape in a disk-shaped measurement target object having a beveled peripheral edge portion, the contour shape measuring method including: a shadow contour shape measuring process of measuring the contour shape as a shadow contour shape on a basis of a shadow image obtained by imaging a shadow of the peripheral edge portion generated by applying light onto the peripheral edge portion from a tangential direction of an outer periphery; an optical contour shape measuring process of measuring the contour shape of the peripheral edge portion as an optical contour shape by measuring a distance to the measurement target object using light from a surface direction; and a contour shape calculating process of obtaining the contour shape on a basis of a shadow contour shape measured by the shadow contour shape measuring process and an optical contour shape measured by the optical contour shape measuring process.

Such a contour shape measuring method includes the optical contour shape measuring process in addition to the shadow contour shape measuring process, and obtains the contour shape on the basis of the shadow contour shape measured by the shadow contour shape measuring process and the optical contour shape measured by the optical contour shape measuring process, so that the contour shape can be measured more accurately.

In another aspect, in the contour shape measuring method described above, the optical contour shape measuring process is an optical sectional contour shape measuring process of measuring the optical contour shape as an optical sectional contour shape from the surface direction by an optical cutting method.

According to this, it is possible to provide the contour shape measuring method that measures the optical contour shape as the optical sectional contour shape by an optical cutting method.

In another aspect, in the contour shape measuring method described above, the optical contour shape measuring process is a confocal contour shape measuring process of measuring the optical contour shape as a confocal contour shape from the surface direction by a confocal method.

According to this, it is possible to provide the contour shape measuring method that measures the optical contour shape as the confocal contour shape by a confocal method.

In another aspect, in the contour shape measuring method described above, the optical contour shape measuring process includes an optical sectional contour shape measuring process of measuring the contour shape of the peripheral edge portion as an optical sectional contour shape by an optical cutting method from a surface direction of one surface of the measurement target object, among one surface and another surface facing the one surface, and a confocal contour shape measuring process of measuring the contour shape of the peripheral edge portion as a confocal contour shape from a surface direction of the other surface by a confocal method, and in the contour shape calculating process, a contour shape on the one surface is obtained on a basis of a shadow contour shape measured by the shadow contour shape measuring process and an optical sectional contour shape measured by the optical sectional contour shape measuring process, and a contour shape on the other surface is obtained on a basis of a shadow contour shape measured by the shadow contour shape measuring process and a confocal contour shape measured by the confocal contour shape measuring process.

Since such a contour shape measuring method includes the optical sectional contour shape measuring process on one surface measurement and the confocal contour shape measuring process on the other surface measurement, the contour shapes of both surfaces in the peripheral edge portion can be measured more accurately.

In another aspect, the contour shape measuring method described above includes a noise removal processing process of obtaining a noise-removed contour shape by removing noise generated in a height direction from an optical contour shape measured by the optical contour shape measuring process, in which the contour shape calculating process obtains the contour shape on a basis of a shadow contour shape measured by the shadow contour shape measuring process and a noise-removed contour shape obtained by the noise removal processing process from an optical contour shape measured by the optical contour shape measuring process. Preferably, in the contour shape measuring method described above, the optical contour shape measuring process is an optical sectional contour shape measuring process of measuring the optical contour shape as an optical sectional contour shape from the surface direction by an optical cutting method, the noise removal processing process obtains a noise-removed contour shape by removing noise generated in a height direction from the optical sectional contour shape measured by the optical sectional contour shape measuring process, and the contour shape calculating process obtains the contour shape on the basis of the shadow contour shape measured by the shadow contour shape measuring process and the noise-removed contour shape obtained by the noise removal processing process from the optical sectional contour shape measured by the optical sectional contour shape measuring process. Preferably, in the contour shape measuring method described above, the optical contour shape measuring process is a confocal contour shape measuring process of measuring the optical contour shape as a confocal contour shape by a confocal method, the noise removal processing process obtains a noise-removed contour shape by removing noise generated in a height direction from the confocal contour shape measured by the confocal contour shape measuring process, and the contour shape calculating process obtains the contour shape on the basis of the shadow contour shape measured by the shadow contour shape measuring process and the noise-removed contour shape obtained by the noise removal processing process from the confocal contour shape measured by the confocal contour shape measuring process. Preferably, in the contour shape measuring method described above, the optical contour shape measuring process includes an optical sectional contour shape measuring process of measuring the contour shape of the peripheral edge portion as an optical sectional contour shape by an optical cutting method from a surface direction of one surface of the measurement target object, among one surface and the other surface facing the one surface, and a confocal contour shape measuring process of measuring the contour shape of the peripheral edge portion as a confocal contour shape by a confocal method from a surface direction of the other surface, the noise removal processing process obtains a first noise-removed contour shape by removing noise generated in a height direction from an optical sectional contour shape measured by the optical sectional contour shape measuring process, and obtains a second noise-removed contour shape by removing noise generated in a height direction from the confocal contour shape measured by the confocal contour shape measuring process, and the contour shape calculating process obtains the contour shape on the basis of a shadow contour shape measured by the shadow contour shape measuring process, a first noise-removed contour shape obtained by the noise removal processing process from an optical sectional contour shape measured by the optical sectional contour shape measuring process, and a second noise-removed contour shape obtained by the noise removal processing process from a confocal contour shape measured by the confocal contour shape measuring process.

Since such a contour shape measuring method obtains the contour shape on the basis of the noise-removed contour shape from which noise has been removed, the contour shape can be measured more accurately.

In another aspect, in the contour shape measuring method described above, in the noise removal processing process, the noise is removed using a threshold corresponding to a variation in height obtained on a basis of an optical contour shape measured by the optical contour shape measuring process.

Since such a contour shape measuring method uses the threshold according to the variation in height, noise can be removed more appropriately, and thus the contour shape can be measured more accurately.

This application is based on Japanese Patent Application No. 2023-64267 filed on April 11, 2023 and Japanese Patent Application No. 2024-42104 filed on March 18, 2024, the contents of which are incorporated therein.

Although the present invention has been appropriately and sufficiently described through the embodiments with reference to the above drawings to express the present invention, it should be recognized that a person skilled in the art can easily modify and/or improve the above-described embodiments. Therefore, unless a modification or improvement made by a person skilled in the art is at a level departing from the scope of rights of the claims described in the claims, the modification or improvement is interpreted to be included in the scope of rights of the claims.

### Industrial Applicability

According to the present invention, it is possible to provide a contour shape measuring device and a contour shape measuring method for measuring a contour shape in a disk-shaped measurement target object having a beveled peripheral edge portion.

## Claims

1. contour shape measuring device that measures a contour shape in a disk-shaped measurement target object having a beveled peripheral edge portion, the contour shape measuring device comprising:
a shadow contour shape measuring unit that measures the contour shape as a shadow contour shape on a basis of a shadow image obtained by imaging a shadow of the peripheral edge portion generated by applying light onto the peripheral edge portion from a tangential direction of an outer periphery;
an optical contour shape measuring unit that measures the contour shape of the peripheral edge portion as an optical contour shape by measuring a distance to the measurement target object using light from a surface direction; and
a contour shape calculating unit that obtains the contour shape on a basis of a shadow contour shape measured by the shadow contour shape measuring unit and an optical contour shape measured by the optical contour shape measuring unit.

2. The contour shape measuring device according to claim 1, wherein the optical contour shape measuring unit is an optical sectional contour shape measuring unit that measures the optical contour shape as an optical sectional contour shape from the surface direction by an optical cutting method.

3. The contour shape measuring device according to claim 1, wherein the optical contour shape measuring unit is a confocal contour shape measuring unit that measures the optical contour shape as a confocal contour shape from the surface direction by a confocal method.

4. The contour shape measuring device according to claim 1, wherein
the optical contour shape measuring unit includes
an optical sectional contour shape measuring unit that measures the contour shape of the peripheral edge portion as an optical sectional contour shape by an optical cutting method from a surface direction of one surface of the measurement target object, among one surface and another surface facing the one surface, and
a confocal contour shape measuring unit that measures the contour shape of the peripheral edge portion as a confocal contour shape from a surface direction of the other surface by a confocal method, and
the contour shape calculating unit obtains a contour shape on the one surface on a basis of a shadow contour shape measured by the shadow contour shape measuring unit and an optical sectional contour shape measured by the optical sectional contour shape measuring unit, and obtains a contour shape on the other surface on a basis of a shadow contour shape measured by the shadow contour shape measuring unit and a confocal contour shape measured by the confocal contour shape measuring unit.

5. The contour shape measuring device according to claim 1, further comprising a noise removal processing unit that obtains a noise-removed contour shape by removing noise generated in a height direction from an optical contour shape measured by the optical contour shape measuring unit,
wherein the contour shape calculating unit obtains the contour shape on a basis of a shadow contour shape measured by the shadow contour shape measuring unit and a noise-removed contour shape obtained by the noise removal processing unit from an optical contour shape measured by the optical contour shape measuring unit.

6. The contour shape measuring device according to claim 5, wherein the noise removal processing unit removes the noise using a threshold corresponding to a variation in height obtained on a basis of an optical contour shape measured by the optical contour shape measuring unit.

7. contour shape measuring method for measuring a contour shape in a disk-shaped measurement target object having a beveled peripheral edge portion, the contour shape measuring method comprising:
a shadow contour shape measuring process of measuring the contour shape as a shadow contour shape on a basis of a shadow image obtained by imaging a shadow of the peripheral edge portion generated by applying light onto the peripheral edge portion from a tangential direction of an outer periphery;
an optical contour shape measuring process of measuring the contour shape of the peripheral edge portion as an optical contour shape by measuring a distance to the measurement target object using light from a surface direction; and
a contour shape calculating process of obtaining the contour shape on a basis of a shadow contour shape measured by the shadow contour shape measuring process and an optical contour shape measured by the optical contour shape measuring process.

8. The contour shape measuring method according to claim 7, wherein the optical contour shape measuring process is an optical sectional contour shape measuring process of measuring the optical contour shape as an optical sectional contour shape from the surface direction by an optical cutting method.

9. The contour shape measuring method according to claim 7, wherein the optical contour shape measuring process is a confocal contour shape measuring process of measuring the optical contour shape as a confocal contour shape from the surface direction by a confocal method.

10. The contour shape measuring method according to claim 7, wherein
the optical contour shape measuring process includes
an optical sectional contour shape measuring process of measuring the contour shape of the peripheral edge portion as an optical sectional contour shape by an optical cutting method from a surface direction of one surface of the measurement target object, among one surface and another surface facing the one surface, and
a confocal contour shape measuring process of measuring the contour shape of the peripheral edge portion as a confocal contour shape from a surface direction of the other surface by a confocal method, and
in the contour shape calculating process, a contour shape on the one surface is obtained on a basis of a shadow contour shape measured by the shadow contour shape measuring process and an optical sectional contour shape measured by the optical sectional contour shape measuring process, and a contour shape on the other surface is obtained on a basis of a shadow contour shape measured by the shadow contour shape measuring process and a confocal contour shape measured by the confocal contour shape measuring process.

11. The contour shape measuring method according to claim 7, further comprising a noise removal processing process of obtaining a noise-removed contour shape by removing noise generated in a height direction from an optical contour shape measured by the optical contour shape measuring process,
wherein the contour shape calculating process obtains the contour shape on a basis of a shadow contour shape measured by the shadow contour shape measuring process and a noise-removed contour shape obtained by the noise removal processing process from an optical contour shape measured by the optical contour shape measuring process.

12. The contour shape measuring method according to claim 11, wherein in the noise removal processing process, the noise is removed using a threshold corresponding to a variation in height obtained on a basis of an optical contour shape measured by the optical contour shape measuring process.
